# FASCICULE DE BREVET EUROPEEN

(11) **EP 0 813 237 B1**
(45) Date de publication et mention de la délivrance du brevet: **08.09.2010**
(21) Numéro de dépôt: 97401314.6
(22) Date de dépôt: 11.06.1997
(51) Int. Cl.: H01L 21/60

(54) **Procédé de montage d'un circuit intégré sur un support et support en résultant**
Verfahren zum Montieren einer integrierten Schaltung auf einem Träger und resultierender Träger
Method for mounting an integrated circuit on a support and resulting support

(30) Priorité: 13.06.1996 FR 9607372
(43) Date de publication de la demande: 17.12.1997
(73) Titulaire: Bull SAS, 78340 Les Clayes-sous-Bois (FR)
(72) Inventeur: Courant, Partick, 78220 Viroflay (FR)
(74) Mandataire: Bonnet, Michel

(56) Documents cités:
- FR-A- 2 386 138
- US-A- 4 842 662
- PATENT ABSTRACTS OF JAPAN vol. 012, no. 009 (E-572), 12 Janvier 1988 & JP 62 169353 A (NEC CORP), 25 Juillet 1987,
- PATENT ABSTRACTS OF JAPAN vol. 007, no. 247 (E-208), 2 Novembre 1983 & JP 58 134454 A (SHARP KK), 10 Août 1983,
- IBM TECHNICAL DISCLOSURE BULLETIN, vol. 37, no. 7, 1 Juillet 1994, page 319 XP000455530 "INNER LEAD BOND LEAD REFORM"
- EDWARDS J C: "NO-BUMP BEAM TAPE" IBM TECHNICAL DISCLOSURE BULLETIN, INTERNATIONAL BUSINESS MACHINES CORP. (THORNWOOD), US, vol. 25, no. 4, 1 September 1982 (1982-09-01), page 1948/1949, XP000577277 ISSN: 0018-8689

## Description

### Domaine de l'invention.

L'invention se rapporte à un procédé de montage d'un circuit intégré sur un support et au support en résultant. Elle s'applique plus particulièrement à la technologie de montage sur bande, appelée communément technologie TAB (Tape-Automated Bonding).

### L'art antérieur.

Les circuits intégrés sont actuellement de fines plaquettes de matériau semi-conducteur sensiblement carrées, les plus grandes ayant environ 15 mm de côté. Elles sont pourvues d'un grand nombre de bornes d'entrée-sortie, de l'ordre de 500. Selon la technologie TAB, chaque circuit intégré est monté sur un support constitué d'un substrat isolant porteur d'une structure métallique conductrice généralement appelée araignée. Les bornes d'entrée-sortie du circuit intégré sont fixées, par une opération dite ILB (Inner Lead Bonding), aux extrémités respectives de conducteurs de l'araignée. Le substrat peut se présenter sous diverses formes. Il peut avoir par exemple la forme d'une bande souple de type film cinématographique pourvu de perforations latérales pour son déplacement et son positionnement et porteur de circuits intégrés disposés suivant sa longueur. Une autre forme courante consiste en un cadre porteur d'un ou plusieurs circuits intégrés.

Un premier type de support TAB classique est fait d'une araignée collée sur un substrat. Ce support se compose donc de trois couches : araignée - adhésif - substrat. Ordinairement, l'araignée est une feuille de cuivre ayant une épaisseur d'environ 17 à 70 µm, la colle est en acrylique ou en époxy, étalée sur une épaisseur d'environ 25 µm, et le substrat est fait d'un matériau organique souple et électriquement isolant, dont l'épaisseur minimale est d'environ 50 µm et couramment de l'ordre de 100 µm. La fabrication du support consiste de manière classique à coller une feuille de cuivre uniforme sur le substrat, et à graver la feuille de cuivre pour former l'araignée. Selon un premier mode de réalisation, le substrat est préformé pour avoir la configuration désirée des ouvertures qu'il comporte. Le préformage est alors fait par découpage mécanique, tel que le poinçonnage. Un second mode consiste à découper le substrat après la formation de l'araignée. Ce support et le montage de circuits intégrés sur ce support ont plusieurs inconvénients.

L'opération ILB a lieu au travers d'ouvertures dans le substrat et la colle. Selon un premier mode de réalisation, les ouvertures sont de petits trous disposés sous les extrémités des conducteurs. La fixation classique de chaque extrémité à la borne correspondante du circuit intégré se fait donc par l'intermédiaire d'une boule de brasure devant avoir un diamètre sensiblement supérieur à la hauteur du trou, qui est au minimum d'environ 75 µm. Ces grosses boules ne peuvent être soudées que sur des bornes larges et obligent le percement de trous larges, de l'ordre de 600 à 800 µm, qui s'opposent à la haute densité désirée des bornes du circuit intégré et de leur connexion. Cependant, la formation de trous larges peut être faite par découpage mécanique du substrat avant de le coller à la feuille de cuivre. Cette découpe offre l'avantage d'être peu coûteuse et bien adaptée à une production à grande échelle, mais elle a le grave inconvénient d'être inapplicable aux hautes densités actuellement disponibles.

Plusieurs solutions ont été proposées pour adapter un support de circuit intégré aux hautes densités. Une solution consiste, après la formation de l'araignée, à percer le substrat de manière chimique ou en utilisant des moyens de découpe fine, tels que le laser. Cependant, la découpe chimique requiert de nombreuses opérations de traitement additionnelles, telles que le dépôt d'une couche photosensible sur le substrat, la sensibilisation et la gravure de cette couche pour former un masque ayant la configuration désirée, la gravure du substrat, l'élimination de la colle, et enfin l'élimination du masque. Ces opérations grèvent notablement le coût du support. Il en est de même pour l'utilisation du laser. En pratique, il s'avère ainsi impossible de faire des productions de pré-études ou de prototypes à petite échelle à des coûts non prohibitifs. En outre, une telle découpe laisse des résidus qui peuvent interagir avec la soudure lors de l'opération ILB et former ainsi une connexion de mauvaise qualité ou peu fiable.

Une autre solution réside dans un second type de support classique, dit à deux couches : araignée - substrat. Pour la fabrication de ce support, on dépose sous vide une fine couche uniforme de cuivre sur une face d'un substrat mince de matériau isolant. Ordinairement, on utilise un substrat de polyimide d'environ 20 µm d'épaisseur, on y dépose sous vide une très fine couche de cuivre, généralement par l'intermédiaire d'une couche d'accrochage, en chrome par exemple, et on fait sélectivement croître le cuivre par voie électrochimique pour former l'araignée. La fine couche de cuivre ayant servi de base à la croissance est éliminée en dehors de la configuration désirée de l'araignée. Le substrat est ensuite gravé chimiquement ou par des moyens de découpe fine, tels que le laser, comme dans le mode de réalisation précédent. En particulier, on notera que l'emploi du polyimide implique la gravure par plasma d'oxygène du substrat. Le plasma d'oxygène n'attaque pas la matière organique, donc la matière photosensible et le polyimide, mais il a l'inconvénient d'avoir un temps de pénétration relativement long, de l'ordre d'un micromètre par minute. On comprend que ce procédé ne peut pas s'appliquer industriellement à un substrat épais. Le support qui en résulte coûte environ trois fois plus cher qu'un support classique à trois couches, dont le substrat est perforé mécaniquement. En outre, la minceur du substrat fait qu'il peut être trop flexible quand il est large, plus de 70 mm par exemple, ce qui rend son utilisation délicate. Mais le support qui en résulte a l'avantage d'être mince et de pouvoir utiliser de petites boules de soudure pour effectuer l'opération ILB.

Encore une autre solution a été présentée dans le document EP-A-0356300 du demandeur. Le support est mixte, en ce qu'il est essentiellement du type classique à trois couches avec substrat préformé et que les extrémités des conducteurs portent un cadre mince perforé pour utiliser de petites boules de soudure lors de l'opération ILB. Il a donc les avantages des deux types classiques précités. La fabrication du cadre mince peut être coûteuse et sa pose est une opération délicate.

Un autre problème consiste à éviter l'emploi de boules dans l'opération ILB. Une solution a été décrite dans le document IBM Technical Disclosure Bulletin, vol. 25, n° 4, septembre 1982, "No-bump beam tape". Selon cette solution, les conducteurs en cuivre doré s'appuient sur le bord du circuit intégré par l'intermédiaire du substrat isolant en polyimide photodéfinissable du support, et un outil de soudure abaisse leurs extrémités pour les souder directement par thermocompression aux bornes du circuit intégré. Chacune de ces bornes est le fond, ordinairement en aluminium, d'une traversée dans la couche de passivation qui recouvre et protège la surface correspondante du circuit intégré. La hauteur d'une traversée est de l'ordre du micromètre. Compte tenu de la faible largeur d'une traversée et sa proximité avec le bord du circuit intégré, il faut un substrat isolant mince pour éviter de trop fléchir l'extrémité du conducteur de façon à l'abaisser jusqu'au fond de la traversée. Ceci explique que le support utilisé est du second type classique précité. Sinon, il faut cambrer les extrémités des conducteurs avant de les souder aux bornes du circuit intégré. Ce cambrage a l'inconvénient d'ajouter une opération délicate et d'utiliser un appareil de cambrage relativement coûteux.

Les mêmes problèmes et inconvénients se présentent en utilisant le procédé décrit dans le document US-A-4917286. Le procédé de montage d'un circuit intégré sur un support est très proche de celui décrit précédemment et consiste à placer le substrat sur la couche de passivation, à mettre en correspondance les trous du substrat avec les traversées, et à fléchir les conducteurs pour les souder directement par ultrasons aux bornes du circuit intégré.

Le document US-A-4 842 662 donne un enseignement similaire au précédent. Les conducteurs sont fléchis avant d'être connectés aux bornes du circuit intégré. L'angle de fléchissement assure que les conducteurs ne viennent en contact avec une partie quelconque du circuit intégré.

Le document Patent Abstract of Japan, vol. 007, n° 247 (E-208) du 2 novembre 1983, JP58 134454 A, 10 août 1983, décrit une structure de conducteurs connectés aux bornes d'entrée-sortie d'un circuit intégré et pourvus d'une cambrure formée dans des conditions similaires pour tous les conducteurs afin d'éviter toute connexion incorrecte des conducteurs. La cambrure réalise aussi un écartement des conducteurs par rapport à la face active du circuit intégré.

Enfin, le document FR-A-2 386 138 décrit le montage d'un support dont les conducteurs sont fixés aux bornes du circuit intégré et sont isolés du bord du circuit intégré par des bossages préalablement formés sur le circuit intégré. La formation préalable de ces bossages est coûteuse, complique le procédé de montage du circuit intégré et nécessite une surface non négligeable de la face active du circuit intégré.

### L'invention.

L'invention a pour but de rendre l'opération ILB indépendante du type de substrat.

Un autre but de l'invention est d'adapter le support à l'opération ILB directe, c'est-à-dire sans l'emploi de boules.

L'invention a pour objet un procédé de montage d'un circuit intégré sur un support, tel que défini par la revendication 1.

Les caractéristiques et avantages de l'invention ressortent de la description qui suit, donnée à titre d'exemple et faite en référence aux figures annexées:
- la figure 1 est une vue partielle en plan du support utilisé dans une première étape du procédé conforme à l'invention pour le montage d'au moins un circuit intégré sur le support;
- la figure 2 est une vue similaire à celle de la figure 1 et illustre une seconde étape du procédé conforme à l'invention
- la figure 3 est une vue en coupe partielle faite suivant la ligne III-III au niveau d'une borne du circuit intégré représenté sur la figure 2 ;
- les figures 4A et 4B sont des vues similaires à celle de la figure 3 et illustrent une troisième étape du procédé conforme à l'invention ;
- la figure 5 est une vue similaire à celle de la figure 3 et illustre une variante de réalisation pouvant se substituer à celle illustrée dans la figure 4B ;
- la figure 6 est une vue similaire à celle de la figure 2 et illustre une quatrième étape du procédé conforme à l'invention, ainsi qu'une utilisation possible du support en résultant ; et
- la figure 7 est une vue similaire à celle de la figure 3 et illustre une variante possible de la troisième étape du procédé conforme à l'invention.

### Description détaillée d'exemples illustratifs de l'invention.

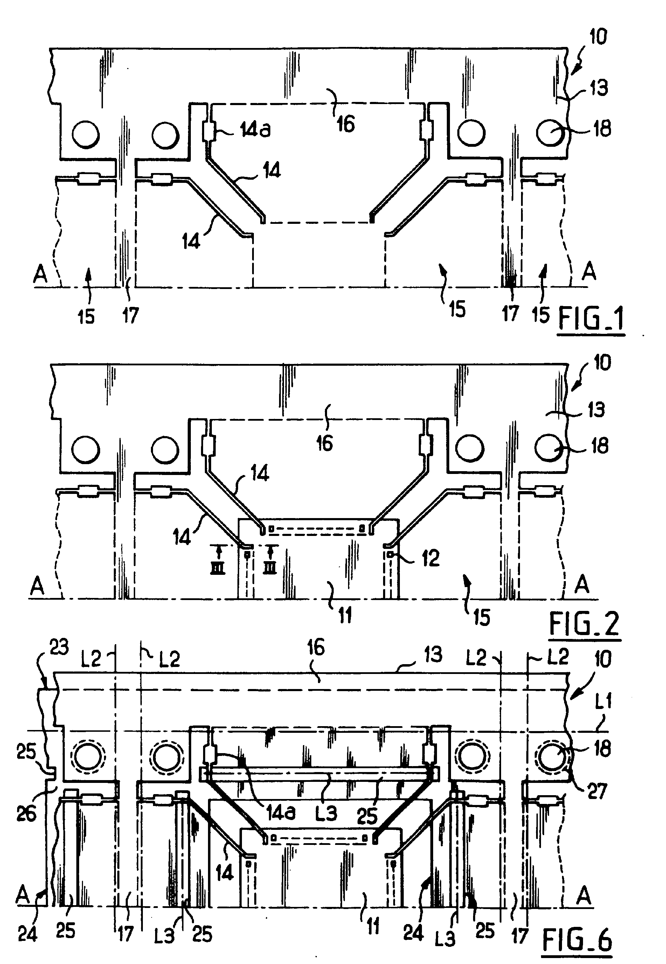

Les figures 1 et 2 illustrent deux étapes d'un exemple préféré de procédé conforme à l'invention pour le montage d'au moins un circuit intégré sur un support. Dans l'exemple choisi et tel que représenté sur les figures 1 et 2, un support 10 sous forme d'une bande souple est utilisé pour le montage d'une pluralité de circuits intégrés 11 présentant des bornes d'entrée-sortie 12 périphériques. Les figures 1 et 2 sont des vues partielles en plan du support 10 ayant un axe longitudinal de symétrie A-A. Pour cette raison, seule une moitié du support délimitée par l'axe A-A est illustrée. D'une manière générale, les dimensions et proportions qui ressortent des figures annexées ne sont pas celles d'un support réel pour des raisons de clarté des dessins. Les dessins annexés sont schématiques et fournis seulement à titre indicatif pour l'homme du métier qui saura les faire correspondre à la réalité sans difficulté et sans ambiguïté.

Le procédé conforme à l'invention commence par l'étape représentée sur la figure 1. Cette étape consiste à utiliser une structure 13 de conducteurs 14. La structure illustrée 13 est une bande constitutive du support 10 et sera appelée araignée. Sa fabrication peut être classique, consistant à graver une bande de cuivre plane et uniforme de façon à former les conducteurs 14 de l'araignée. Les conducteurs 14 sont disposés dans des secteurs 15 se succédant suivant la longueur de la bande. Dans chaque secteur, les conducteurs 14 ont des extrémités libres positionnées en correspondance avec les bornes 12 d'un circuit intégré 11, comme indiqué à la figure 2, et ont des extrémités opposées attachées à au moins l'un des deux bords continus 16 de l'araignée. Les bords illustrés 16 portent les conducteurs 14 s'étendant sensiblement dans la direction perpendiculaire aux bords. Les bords 16 sont réunis entre eux par des barrettes 17 délimitant transversalement les secteurs 15. Les barrettes servent de support aux conducteurs s'étendant sensiblement dans la direction longitudinale de l'araignée. Pour la clarté des dessins, seuls les deux conducteurs 14 placés dans les deux positions extrêmes des quatre groupes de conducteurs sont illustrés, la présence des autres conducteurs étant suggérée par des traits tiretés intermédiaires aux extrémités respectives de ces conducteurs. Les conducteurs 14 présentent aussi des plages de test 14a au voisinage des bords 16 et des barrettes 17 auxquels les conducteurs sont attachés. L'araignée 13 présente en outre des moyens 18 servant à son positionnement. Les moyens illustrés sont des trous ronds 18 placés dans les quatre coins de chaque secteur 15 et ménagés dans des extensions de cuivre au niveau de la jonction des bords 16 avec les barrettes 17. Dans l'exemple illustré, les trous 18 servent aussi au déplacement de l'araignée. Cependant, des moyens de déplacement pourraient être ajoutés, tels que par exemple des trous (non illustrés) régulièrement espacés dans chacun des bords, du type bande cinématographique. Dans ce cas, ces trous pourraient aussi servir au positionnement. Dans l'exemple choisi, l'araignée 13 est une structure continue de cuivre, uniformément dorée par électrodéposition.

La figure 2 illustre la seconde étape du procédé conforme à l'invention.

Les extrémités libres des conducteurs 14 de chaque cadre 15 sont fixées par une opération ILB aux bornes respectives 12 d'un circuit intégré. L'opération ILB illustrée est du type direct, faite par exemple par thermocompression ou par ultrasons.

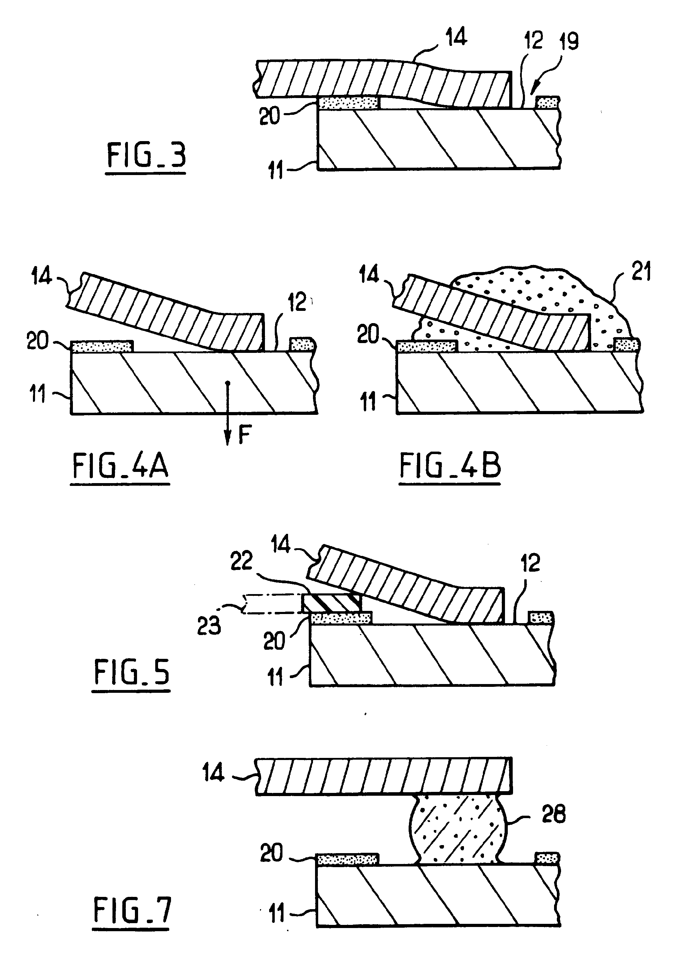

La figure 3 est une vue en coupe partielle et de détail agrandi d'un conducteur 14 connecté à une borne 12 du circuit intégré 11. La borne 12 est formée par le fond d'une traversée 19 faite dans la couche de passivation 20 recouvrant la face active du circuit intégré. Ordinairement, la hauteur d'une traversée 19 est de l'ordre du micromètre, alors qu'un conducteur 14 a une épaisseur de 17 à 70 µm. Dans ces conditions, les extrémités des conducteurs 14 ne sont pratiquement pas fléchies pour les amener au fond des traversées respectives 19. L'opération ILB ne pose donc aucun problème. En outre, elle se fait ici en l'absence totale de substrat isolant.

Les figures 4A et 4B sont des vues similaires à celle de la figure 3 et illustrent la troisième étape du procédé. Cette étape consiste à isoler électriquement les conducteurs 14 du circuit intégré 11, c'est-à-dire à éviter qu'un conducteur vienne en contact avec la face correspondante du circuit intégré. Dans l'exemple choisi, une force F perpendiculaire au plan du circuit intégré est exercée sur lui pour écarter les conducteurs 14 de la couche de passivation 20, comme indiqué à la figure 4A. En référence à la figure 4B, une résine isolante 21 est déposée et, en se solidifiant, elle maintient écartés les conducteurs 14 sans la présence de la force F. La résine 21 peut être une goutte déposée au niveau de chaque conducteur, ou bien un écoulement continu suivant un groupe ou la totalité des conducteurs, ou elle peut recouvrir en tout ou partie la face active du circuit intégré.

La figure 5 est une vue similaire à celle de la figure 3 et illustre un exemple de réalisation pouvant se substituer à celui de la figure 4B. Au lieu d'employer une résine, l'écartement entre les conducteurs et la couche de passivation est maintenu par l'insertion de moyens formant entretoise 22. Ces moyens peuvent être faits d'une lamelle de matériau isolant disposée sous chaque groupe de conducteurs placés sur un côté du circuit intégré. Chaque lamelle peut être aussi fixée sur la couche de passivation 20 comme illustré, ou sous les conducteurs 14.

La figure 6 est une vue similaire à celle des figures 1 et 2. Dans la figure 6, un substrat isolant 23 est fixé à l'araignée 13. Le substrat peut être monobloc ou fait de pièces, percées ou non. Les pièces peuvent aussi être simultanément ou successivement positionnées et fixées à l'araignée. Le substrat illustré 23 est une bande monobloc, coaxiale à l'axe A-A, dont les bords recouvrent en partie les bords 16 de l'araignée 13. Il se compose de cadres 24 successifs, monoblocs et fixés aux conducteurs 14 dans les secteurs respectifs 15. Chaque cadre illustré 24 est rectangulaire, dont les quatre côtés intérieurs sont placés parallèlement et extérieurement aux quatre côtés respectifs du circuit intégré 11. Il est percé de quatre fenêtres 25 s'étendant suivant chaque côté intérieur du cadre et séparées entre elles par des bras 26 placés aux quatre coins respectifs du cadre. En outre, quatre trous 27 sont ménagés coaxialement aux trous de positionnement 18 et ont un plus grand diamètre que les trous 18. Comme les fenêtres et les trous ont de grandes dimensions, le substrat peut être perforé mécaniquement au moindre coût.

Le substrat illustré 23 est fixé après la connexion des conducteurs 14 aux bornes 12 du circuit intégré 11. Puisque chaque cadre 24 est écarté de l'aire prévue pour le circuit intégré, il ne peut plus gêner la connexion directe. Il s'ensuit que le substrat 23 pourrait être placé avant l'étape de connexion. Dans ce cas, la figure 6 viendrait s'insérer entre les figures 1 et 2.

D'autre part, les étapes représentées sur les figures 5 et 6 pourraient être fusionnées. Selon un premier exemple de fusion, la mise en place des entretoises 22 pourrait se faire en même temps que celle du substrat 23. Selon un second exemple, les quatre entretoises 22 sont des parties solidaires des quatre côtés intérieurs du cadre 24 correspondant, comme représenté de façon schématique par un trait mixte sur la figure 5. Dans ce cas, si l'insertion des entretoises 22 entre les conducteurs 14 et le circuit intégré 11 est difficile, une solution pourrait consister à former chaque cadre 24 de quatre quadrants séparés, correspondant chacun à un côté du circuit intégré.

La figure 6 illustre aussi par des lignes en trait fantôme l'usage ultérieur du support 10. Les deux lignes L1 parallèles aux bords 16 de l'araignée 13 illustrent deux lignes de découpe du support 10. Une découpe des conducteurs 14 rattachés aux bords 16 est faite entre les bords 16 et les plages de test 14a des conducteurs 14. De même, les conducteurs 14 rattachés aux barrettes 17 sont découpés suivant des lignes L2 parallèles aux barrettes 17 et situées entre les plages de test 14a et les barrettes. Ces lignes de découpe séparent ainsi les secteurs 15 entre eux. En outre, elles isolent les conducteurs 14 les uns des autres et permettent de faire le test électrique du circuit intégré 11.

De la figure 6 apparaissent aussi trois de quatre lignes L3 de découpe des conducteurs 14 suivant l'axe des fenêtres 25 de chaque cadre 24. Ces lignes illustrent la découpe faite pour détacher le circuit intégré 11 du secteur correspondant 15 et fixer le circuit intégré sur une carte de connexion, telle qu'une carte de circuits imprimés. Cette découpe est communément appelée opération OLB (Output Lead Bonding).

La figure 7 est vue similaire à celle de la figure 3 et illustre une variante de connexion des conducteurs 14 aux bornes 12 du circuit intégré 11. L'opération ILB est indirecte, faite ici de manière classique par l'intermédiaire de boules de soudure 28. Ces boules se trouvent préalablement dans les traversées. Elle pourrait aussi être faite par l'intermédiaire d'éléments similaires aux boules et utilisés pour rehausser les bornes d'entrée-sortie 12 du circuit intégré 11. La connexion est faite sans l'intermédiaire de partie du support qui isole les conducteurs du circuit intégré et qui est utilisée traditionnellement dans la technologie TAB. Une entretoise 22 telle que celle illustrée dans la figure 5 peut être facilement insérée ultérieurement.

D'une manière générale, il ressort de la description qui précède que l'invention a pour objet un procédé de montage d'un circuit intégré 11 sur un support 10 comprenant une structure 13 de conducteurs 14 prévus pour la connexion des bornes d'entrée-sortie 12 du circuit intégré, le procédé consistant à connecter les conducteurs aux bornes respectives du circuit intégré sans faire intervenir une partie du support pour isoler les conducteurs du circuit intégré. L'isolement par une matériau isolant entre les conducteurs et le circuit intégré est effectué après la connexion des conducteurs.

Ce procédé offre deux avantages majeurs. Comme premier avantage, il se libère des contraintes imposées précédemment par la présence d'un substrat. Dans le mode de réalisation préféré de l'invention tel qu'illustré dans les figures 1 à 6, le substrat est seulement fixé après la connexion et l'isolement des conducteurs. Cependant, puisque le substrat ne sert qu'à supporter les conducteurs à l'extérieur du circuit intégré, on a vu qu'il peut être ajouté avant l'isolement des conducteurs, ou encore au moment de l'isolement. Comme second avantage, il permet de faire des opérations ILB directes, sans boules de connexion et sans pratiquement fléchir les conducteurs. Mais on a vu que les opérations ILB indirectes sont aussi possibles. La mise en oeuvre du procédé est donc simple, permet une grande souplesse dans l'adaptation du procédé à tous les cas, et peut se faire à faible coût.

L'isolation illustrée dans les figures 4A et 4B consiste à écarter les conducteurs du circuit intégré et à les maintenir écartés. L'écartement est obtenu par l'action d'une force F et est maintenu par dépôt et solidification d'un matériau électriquement isolant, tandis qu'à la figure 5 il est maintenu par l'insertion de moyens électriquement isolants formant entretoise entre les conducteurs et le circuit intégré. Dans ce cas, on a vu que si ces moyens sont des parties solidaires d'un substrat isolant, l'isolement peut se faire en même temps que la mise en place du substrat. En d'autres termes, le procédé peut alors consister simplement à fixer le substrat aux conducteurs pour maintenir l'isolement. Ce mode d'isolation n'est pas le seul applicable. Par exemple, l'isolation pourrait être faite par un cambrage préliminaire des conducteurs, de préférence maintenu par application d'une résine ou d'une lamelle isolante, comme illustré dans les figures 4B et 5. Dans ce cas, l'isolation pourrait simplement être faite sans avoir à écarter les conducteurs au préalable. On peut donc que si les moyens d'isolation 22 sont des parties solidaires d'un substrat isolant 23, l'isolation peut se faire en même temps que la fixation du substrat 23 aux conducteurs 14, sans nécessairement avoir à écarter les conducteurs après leur connexion.

Dans l'exemple illustré, la structure de conducteurs est pourvue de moyens de positionnement 18 et le procédé conserve ces moyens de positionnement après la fixation du substrat. Dans la technique antérieure, les moyens de positionnement du support sont formés dans le substrat isolant. Celui-ci étant ordinairement fait d'une matière plastique, les trous peuvent difficilement offrir un positionnent précis et fiable. Au contraire, les trous 18 de positionnement du support de l'invention sont formés dans la structure métallique constituant l'araignée 13. Les trous 18 permettent facilement un positionnement précis et fiable du support 10. Dans l'exemple illustré, les trous de positionnement 18 sont plus petits que les trous 27 du substrat et conservent donc leur fonction de positionnement précis et fiable après la découpe du support.

Il résulte de la mise en oeuvre du procédé un support d'au moins un circuit intégré, comprenant une structure de conducteurs connectés aux bornes d'entrée-sortie respectives du circuit intégré sans l'intermédiaire d'une partie du support qui isole les conducteurs du circuit intégré. La connexion directe ne nécessite aucun cambrage et pratiquement aucune flexion des conducteurs. La structure suffit à elle seule, sans nécessiter de substrat.

Dans l'exemple illustré, la structure est fixée à un substrat extérieur au circuit intégré. Cependant, elle peut être étendue dans l'aire du circuit intégré dans le cas où le substrat réalise aussi l'isolement, comme indiqué en référence à la figure 5. Dans la figure 4B, la substance isolante 21 n'est pas une partie du substrat ou du support et a été apportée.

## Revendications

1. Procédé de montage d'un circuit intégré (11) sur un support (10) comprenant une structure (13) de conducteurs (14) prévus pour la connexion des bornes d'entrée-sortie (12) disposées sur une face du circuit intégré, chacun des conducteurs (14) comprenant respectivement une extrémité libre et un corps associé, **caractérisé en ce qu'**il comprend ;
- i) une étape de connexion de l'extrémité libre de chacun des conducteurs (14) de la structure (13) à une borne respective (12) du circuit intégré (11),
- ii) une étape d'écartement pour séparer les corps des conducteurs (14) de ladite face du circuit intégré (11) par application d'une force (F) perpendiculaire à ladite face du circuit intégré (11) de façon à isoler électriquement le corps des conducteurs (14) de ladite face du circuit intégré, tout en conservant la connexion par l'extrémité libre desdits conducteurs (14), puis
- iii) une étape de maintien de la séparation entre le corps desdits conducteurs (14) par rapport à ladite face du circuit intégré (11), par application de moyens d'isolation électrique (21, 22) entre au moins ledit corps et ladite face du circuit intégré.

2. Procédé selon la revendication 1, **caracterisé en ce que** l'écartement est maintenu par dépôt et solidification d'un matériau électriquement isolant (21) constituant lesdits moyens d'isolation,

3. Procédé selon la revendication 1, **caractérisé en ce que** l'écartement est maintenu par insertion desdits moyens d'isolation, formant entretoise (22), entre les conducteurs (14) et ladite face du circuit intégré (11).

4. Procédé selon la revendication 1, **caractérisé en ce qu'**il consiste à fixer aux conducteurs (14) un substrat isolant (23) extérieur à ladite face du circuit intégré et pourvu des moyens d'isolation formant entretoise (22) et à maintenir l'écartement des conducteurs par insertion des moyens formant entretoise (22) entre les conducteurs et ladite face du circuit intégré.

5. Procédé selon l'une des revendications 1 à 3, **caractérisé en ce que**, avant ou après la connexion du circuit intégré au support, il consiste à fixer aux conducteurs (14) un substrat isolant (23) extérieur à ladite face du circuit intégré (11).

6. Procédé selon l'une des revendrions 1 à 5, **caractérisé en ce que** la connexion des extrémités libres des conducteurs (14) aux bornes du circuit intégré est faite indirectement, par l'intermédiaire de boules ou d'éléments similaires servant à rehausser les bornes d'entrée-sortie du circuit intégré (11).

7. Procédé selon l'une des revendications 1 à 5, **caractérisé en ce que** la connexion des extrémités libres des conducteurs est faite directement sur les bornes correspondantes (12) du circuit intégré.

## Claims

1. Method for mounting an integrated circuit (11) on a support (10) comprising a structure (13) of conductors (14) provided for the connection of the input-output terminals (12) arranged on one face of the integrated circuit, each of the conductors (14) comprising respectively a free end and an associated body, **characterised in that** it comprises:
- i) a step of connecting the free end of each of the conductors (14) of the structure (13) to a respective terminal (12) of the integrated circuit (11),
- ii) a spacing step for separating the bodies of the conductors (14) from said face of the integrated circuit (11) by application of a force (F) perpendicular to said face of the integrated circuit (11) so as to electrically insulate the body of the conductors (14) from said face of the integrated circuit, while preserving the connection by the free end of said conductors (14), then
- iii) a step of maintaining the separation between the body of said conductors (14) from said face of the integrated circuit (11), by application of electrical insulation means (21, 22) between at least said body and said face of the integrated circuit.

2. Method according to Claim 1, **characterised in that** the spacing is maintained by deposition and solidification of an electrically insulating material (21) constituting said insulation means.

3. Method according to Claim 1, **characterised in that** the spacing is maintained by insertion of said insulation means, forming a spacer (22), between the conductors (14) and said face of the integrated circuit (11).

4. Method according to Claim 1, **characterised in that** it consists in fixing to the conductors (14) an insulating substrate (23) outside said face of the integrated circuit and provided with insulation means forming a spacer (22) and in maintaining the spacing of the conductors by insertion of the means forming a spacer (22) between the conductors and said face of the integrated circuit.

5. Method according to one of Claims 1 to 3, **characterised in that**, before or after the connection of the integrated circuit to the support, it consists in fixing to the conductors (14) an insulating substrate (23) outside said face of the integrated circuit (11).

6. Method according to one of Claims 1 to 5, **characterised in that** the connection of the free ends of the conductors (14) to the terminals of the integrated circuit is performed indirectly, by means of balls or similar elements that serve to raise the input-output terminals of the integrated circuit (11).

7. Method according to one of Claims 1 to 5, **characterised in that** the connection of the free ends of the conductors is performed directly on the corresponding terminals (12) of the integrated circuit.

## Patentansprüche

1. Verfahren zum Anbringen eines integrierten Schaltkreises (11) auf einem Träger (10), der eine Struktur (13) von Leitungen (14) aufweist, die für die Verbindung mit Eingangs-Ausgangs-Anschlüssen (12), die auf einer Fläche des integrierten Schaltkreises angeordnet sind, vorgesehen sind, wobei jede der Leitungen (14) jeweils ein freies Ende und einen zugehörigen Körper aufweist, **dadurch gekennzeichnet, dass** das Verfahren Folgendes umfasst:
- i) einen Verbindungsschritt, bei dem das freie Ende jeder Leitung (14) der Struktur (13) mit einem entsprechenden Anschluss (12) des integrierten Schaltkreises (11) verbunden wird,
- ii) einen Abrückschritt, bei dem der Körper der Leitungen (14) von der Fläche des integrierten Schaltkreises (11) durch Anwenden einer Kraft (F), die senkrecht ist zu der Fläche des integrierten Schaltkreises (11), getrennt wird, sodass der Körper der Leitungen (14) von der Fläche des integrierten Schaltkreises elektrisch isoliert wird, wobei die Verbindung über die freien Enden der Leitungen (14) erhalten bleibt, dann
- iii) einen Aufrechterhaltungsschritt, mit dem die Trennung zwischen dem Körper der Leitungen (14) und der Fläche des integrierten Schaltkreises (11) durch Aufbringen von elektrischen Isolierungsmitteln (21, 22) wenigstens zwischen dem Körper und der Fläche des integrierten Schaltkreises aufrecht erhalten wird.

2. Verfahren gemäß Anspruch 1, **dadurch gekennzeichnet, dass** die Abrückung durch Abscheiden und Aushärten eines elektrisch isolierenden Materials (21), das die Isolierungsmittel bildet, aufrechterhalten wird.

3. Verfahren gemäß Anspruch 1, **dadurch gekennzeichnet, dass** die Abrückung durch Einfügen von ein Abstandsstück (22) bildenden Isolierungsmitteln zwischen den Leitungen (14) und der Fläche des integrierten Schaltkreises (11) aufrechterhalten wird.

4. Verfahren gemäß Anspruch 1, **dadurch gekennzeichnet, dass** es darin besteht, auf den Leitungen (14) ein isolierendes Substrat (23) außerhalb der Fläche des integrierten Schaltkreises zu befestigen, wobei das isolierende Substrat Isolierungsmittel aufweist, die ein Abstandsstück (22) bilden, und die Abrückung der Leitungen durch Einfügen der ein Abstandsstück bildenden Mittel (22) zwischen den Leitungen und der Fläche des integrierten Schaltkreises aufrechtzuerhalten.

5. Verfahren nach einem der Ansprüche 1 bis 3, **dadurch gekennzeichnet, dass** es darin besteht, vor oder nach der Verbindung des integrierten Schaltkreises mit dem Träger ein isolierendes Substrat (23) außerhalb der Fläche des integrierten Schaltkreises (11) auf den Leitungen (14) zu befestigen.

6. Verfahren nach einem der Ansprüche 1 bis 5, **dadurch gekennzeichnet, dass** die Verbindung der freien Enden der Leitungen (14) mit den Anschlüssen des integrierten Schaltkreises indirekt über Kugeln oder ähnliche Elemente erfolgt, die dazu dienen, die Eingangs-Ausgangs-Anschlüsse des integrierten Schaltkreises (11) höher zu legen.

7. Verfahren nach einem der Ansprüche 1 bis 5, **dadurch gekennzeichnet, dass** die Verbindung der freien Enden der Leitungen direkt auf den entsprechenden Anschlüssen (12) des integrierten Schaltkreises erfolgt.
